# EUROPEAN PATENT APPLICATION

(11) **EP 3 326 816 A1**
(43) Date of publication of application: **30.05.2018**
(21) Application number: 16201181.1
(22) Date of filing: 29.11.2016
(51) Int. Cl.: B33Y 80/00, F16B 5/06, F16B 21/07, F16B 33/00, F16B 1/00

(54) **A PROCESS FOR REVERSIBLY CONNECTING AT LEAST TWO ELEMENTS WITH 3D PRINTED CONNECTORS**

(71) Applicant: CSEM Centre Suisse d'Electronique et de Microtechnique SA - Recherche et Développement, 2002 Neuchâtel (CH)
(72) Inventor: LANI, Sébastien, 1784 Courtepin (CH); BARROT, François, 3235 Erlach (CH)
(74) Representative: Gevers SA

(57) **Abstract**

The present invention relates to a process for reversibly assembling at least two elements (1, 2) comprising the steps of providing at least a first connector (3), and connecting the at least two elements (1, 2) by means of the first connector (3), wherein the at least first connector (3) is formed by additive manufacturing techniques without molding or masking, in particular 3D printing, and wherein the connector and/or the elements (1,2) are configured to undergo elastic or plastic deformation upon connection and/or disconnection of the two parts (1,2).

## Description

### Technical field

The present invention relates altogether to the field of microtechniques and to the field of additive manufacturing techniques, such as 3D printing techniques. It relates more specifically to a process for reversibly assembling two elements such as MEMS devices or the like by means of micro-connectors obtained by additive manufacturing techniques.

### Prior art

Multiple assembly techniques are known in the art for assembling solid components together at a macroscale level, either irreversibly, i.e. the assembled components may not be disassembled without breaking them apart or damaging them to such an extent their functionalities be affected, or reversibly, i.e. the components may be disassembled without breaking or losing functionality at least one time, preferably multiple times.

A non-exhaustive list of irreversible assembly techniques comprises for example gluing, bonding, soldering, welding, nailing, riveting.

Likewise, a non-exhaustive list of reversible assembly techniques comprises for example screwing, clipping, clamping, hook and loop fastening, magnetic assembly, zipping, taping.

The choice between a reversible or irreversible assembly between components mostly depends of course mostly on the nature of the components, the technical performance of the assembly and its expected use(s) as well as durability through the times.

In some technical fields and in microtechnologies in particular implementation of reversible assembly techniques prove to be extremely challenging. Indeed, the reduced size of the products and therefore of their components, often ranging from a few tenths of millimetres to a few millimetres at most, makes it hard to conceive or implement assembly means of like size or even smaller to avoid affecting the overall product dimensions, while being easy and cost effective to manufacture and implement, as well as being technically reliable in their assembly function.

Clamping through screwing has already been proposed in the field of microprocessors manufacturing. However, there's a huge risk of damage of the parts made of brittle materials like silicon.

A Silicon hook and loop-like assembly system has also been proposed for chip assembly in WO 2007/017458 A1. It describes a connection arrangement comprising at least two microcomponents having a nanostructured silicon surface with a multiplicity of wedge-shaped nano-objects made through Deep Reactive-Ion Etching, commonly know under the DRIE acronym, that are uniformly distributed statistically.

US 6393685 further discloses a wafer level interconnecting mechanism for assembling and packaging multiple MEMS devices (modules), using microfabricated, interlocking, mechanical joints to interconnect different modules and to create miniature devices. The disclosed interconnecting mechanism also results from anisotropic etching techniques such as DRIE. However such etching techniques are expensive, require provision of masks to selectively etch the substrates and are limited in terms of shapes of the etched parts

WO 2011/071212 A1 disclosed a dry-attachment fastening system comprising a first attachment member having first microfibre hairs formed on a first substrate, and a second attachment member having second microfibre hairs formed on a second substrate, which create a reversible link to each other when brought in contact through Van der Waals forces. The hairs may be formed through lithography on a polymer surface. However, such fastening system does not provide sufficient strength between the attached components to allow them undergo operational constraints of mechanical stress, nor does it allow for combining additional technical functions to the fastening such as fluidic, light and/or electrical conduction.

### Disclosure of the invention

It is an aim of the invention to provide a simple, affordable and versatile technique for reversibly assembling components or modules of microsystems such as in particular MEMS, MacroMEMS, BioMEMS, MOEMS or NEMS.

Another aim of the invention to provide an assembly technique for components of microsystems of the kind defined above which would allow either a simple mechanical connection or both mechanical and fluidic connection, mechanical and electrical connection or even mechanical and optical connection for instance.

The present invention achieves the previously defined objectives by providing a process for reversibly assembling at least two elements comprising the steps of
- providing at least a first connector, and
- connecting the at least two elements by means of the first connector,
wherein the at least first connector is formed by additive manufacturing technique without molding or masking, and wherein the connector and/or the elements are configured to undergo elastic or plastic deformation upon connection and/or disconnection of the two parts.

The process according to the present invention provides for the making of connectors using current additive manufacturing techniques, also known as 3D printing, on the surface of components or modules of a microsystem such as a MEMS device to attach said components or modules by plugging them together with the micro connectors. Such plugging effect is allowed by partial deformation of the connectors and/or the material of the components, in particular when such comprise complementary connectors or complementary recesses or holes arranged in their surface to ensure proper tight fitting of a connector of another component therein.

In the context of the invention, the terms "additive manufacturing" and "3D printing" are used and are to be interpreted as synonyms and they encompass in particular all manufacturing techniques referred to by the company 3D Hubs Inc. in https://www.3dhubs.com/what-is-3d-printing#technologies, to the exclusion of sheet lamination techniques by laminated object manufacturing (LOM).

Accordingly additive manufacturing techniques contemplated in the present invention comprise, material jetting, nanoparticle jetting, drop on demand technique, binder jetting, multijet fusion, selective laser sintering, direct metal laser sintering, selective laser melting, aerosol jet printing, stereolithography, digital light processing, continuous digital light processing, fused filament deposition modelling, electron beam melting, electron beam additive manufacturing, laser engineering net shape or any combination thereof. The choice of a bespoke technique can in particular be made depending upon the nature and thermal behaviour of the components whereupon the connectors must be formed, the mechanical resistance of the connectors and their dimensions, and of course the applications to which the manufactured components are dedicated.

In various embodiments of the invention, the first connector is made of a material comprising a polymer, a metal, a metallic alloy, a ceramic or a combination thereof.

In embodiments of the invention, any dimension of said at least first connector in any dimension X,Y,Z of space is comprised between at least 10 microns and at most 5 mm. Preferably, any dimension of said at least first connector in any dimension X,Y,Z of space is comprised between at least 100 microns and 1 mm, still preferably between 100 and 500 microns.

In a first preferred embodiment, the first connector is a pin and connecting the at least two elements comprises pining the two elements together by means of the at least first connector.

In said first embodiment the two elements comprise each at least one hole having complementary shape and size with the at least one connector so that it can be inserted in and removed from said hole by elastic or plastic deformation of the connector and/or hole walls.

In a second embodiment the at least first connector may be formed onto one of the two elements and the other one of the two elements comprises at least one hole having complementary shape and size with the at least one connector so that it can be inserted in and removed from said hole by elastic or plastic deformation of the connector and/or hole walls.

In a third embodiment of the invention the first connector may be formed on a first one of the two elements and wherein at least a second connector is provided on the second one of the two elements, said first and second connectors having complementary male and female shapes such that one connector can be inserted into the other connector by elastic deformation of one or both connectors to connect said two elements.

In this third embodiment, a first connector may be a pin extending perpendicularly from a surface of one of the two elements comprising a peripheral groove and the second connector comprises flexibles hooks extending perpendicularly from a surface of the second element and being flexible and arranged with respect to each other such that connection of the two elements results from insertion of the first connector between of the hooks of the second connector and clipping of the hooks in the groove of the first connector.

In yet another embodiment of the invention, the first and second connectors are tubular and comprise at least a central channel extending along a length of said connectors said channels communicating with each other upon insertion of the connectors into each other to connect the two elements. In such configuration the first and second connectors not only allow for mechanical assembly of the two elements but further allow for fluidic connection at the same time, thereby offering an extremely modular and multifunctional solution for microsystems' design.

Preferably in such fluidic-enabled connecting solution the first and second connectors are arranged such that connection between the two elements is air and fluid tight at the connectors.

In yet another embodiment of the invention the channel in the first and second connectors may be filled with electrically conductive material or optically conductive material. Such electrically conductive material or optically conductive material may then be deposited preferably in the channel by any additive manufacturing technique previously defined. The conductive material (electrical or optical) may further be deposited in layers together with the material of the first/and or second connector(s) or even form said connectors entirely.

Filling the channel in the connectors with electrically or optically conductive material advantageously provides for electrical or optical connection between two elements of a microsystems, which is rather difficult, if ever possible, to achieve without complex insolation techniques or bulky intermediate connectors in microsystems currently."

Alternatively, the first connector and/or a second connector may be formed of electrically or optically conductive material directly by additive manufacturing technique as previously described

In embodiments of the invention where a first and second connectors are contemplated then said at least second connector preferably also has a longest dimension in any dimension X,Y,Z of space of at least 10 microns and of at most 5 mm, preferably between at least 100 microns and 1 mm, still preferably between 100 and 500 microns.

### Presentation of drawings

The invention will be described in more details in relation to several embodiments thereof represented in the appended drawings among which :
- Figure 1A and 1B represent a first embodiment of the process of the invention, pre-assembly and post-assembly of two elements respectively;
- Figure 2A and 2B represent a second embodiment of the process of the invention, pre-assembly and post-assembly of two elements respectively;
- Figure 3A and 3B represent a third embodiment of the process of the invention, pre-assembly and post-assembly of two elements respectively;
- Figure 4A and 4B represent a fourth embodiment of the process of the invention, pre-assembly and post-assembly of two elements respectively
- Figure 5A and 5B represent a variant of the process of the invention as represented in figure 3A and 3B where fluidic connection is arranged between two elements by means of printed first and second connectors comprising a central channel, pre-assembly and post-assembly of two elements respectively;
- Figure 6A and 6B represent a variant of the process of the invention as represented in figure 3A and 3B where electrical or optical connection is arranged between two elements by means of printed first and second connectors comprising a central channel filled with an electrically or optically conductive material, pre-assembly and post-assembly of two elements respectively;
- Figures 7A and 7B represent a variant of the process of the invention as represented in figure 3A and 3B where optical connection is arranged between two elements by means of printed first and second connectors comprising a central channel filled with an optically conductive material, pre-assembly and post-assembly of two elements respectively.

### Description of prefered embodiments

The present invention relates to and proposes a process for assembling components or modules of microsystems so as to allow easy, reliable, and reversible modular construction of such microsystems.

The method of the invention finds a particular interest and application in the field of microelectromechanical systems (MEMS) and nanoelectromechanical systems (NEMS) and their multiple variants known in the art such as Macro-MEMS, biomedical or biological microelectromechanical systems (BioMEMS) or micro-optoelectronic mechanical systems (MOEMS).

The process of the invention will further find interesting applications in the field of precision mechanics such as horology for the design of replaceable tiny mechanical pieces of wristwatches or the like for example.

The process of the invention essentially provides for the realization by additive manufacturing techniques of connectors for ensuring assembly of two elements of a microsystems of the kind previously described by effect of elastic or plastic deformation at an interface between the connectors and/or an interface between a connector and a connecting part of one of the elements to be assembled of having a shape complementary to that of the connector to allow proper fitting about the latter.

Additive manufacturing techniques, also known more widely as 3D printing techniques, allow for easy and cheap design of microscale individual connectors which can be used as interlinking members between MEMS or NEMS modules for example, or be formed directly on surfaces of such modules after manufacturing of those without the complexities of etching processes, nor the fragility of connectors formed in the matter of the modules, which in the case of brittle materials such as silicon, much used in the field of microsystems, can be a critical cause of failure of the assembly.

The process of the invention takes advantages of the recent improvements in terms of additive manufacturing techniques to provide a new and reliable method for reversibly assembling at least two elements of microsystems. According to the invention this method essentially comprises the steps of :
- providing at least a first connector, and
- connecting the at least two elements by means of the first connector,
wherein the at least first connector is formed by additive manufacturing techniques, in particular 3D printing, and wherein the connector and/or the elements are configured to undergo elastic or plastic deformation upon connection and/or disconnection of the two elements.

In the context of the invention, as previously introduced, the terms "additive manufacturing" and "3D printing" are used and are to be interpreted as synonyms and they encompass in particular all manufacturing techniques referred to by the company 3D Hubs Inc. in https://www.3dhubs.com/what-is-3d-printing#technologies, to the exclusion of sheet lamination techniques by laminated object manufacturing (LOM).

Various embodiments of the process of the invention are described hereinafter building on the above generic principle of the invention.

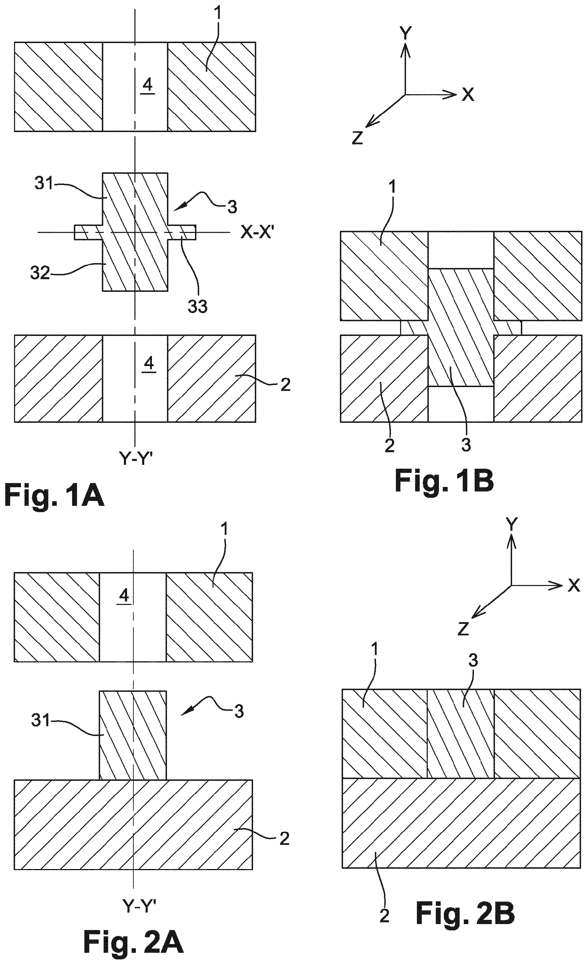

Referring to Figures 1A and 1B a first embodiment of the process of the invention is represented, wherein a first element 1 and a second element 2 are assembled together in a reversible manner by means of a single 3D printed connector 3 configured to engage identically in connecting holes 4 arranged in the first and second elements 1, 2.

The first and second elements 1, 2 can for example be made preferably of silicon and the connecting holes 4 may advantageously be made by etching in the silicon surface of elements 1, 2 according to any known etching technique, such as DRIE in particular.

The first and second elements 1, 2 may also be made of a metal, a metallic alloy, ceramic, a polymer, or a combination thereof. In such case then the connecting holes 4 may advantageously be machined in the material of the elements, for example by drilling.

The connector 3 is advantageously formed by additive manufacturing as recited previously, for example in that first example by stereolithography from a polymer material, or a composite ceramic/polymer or metal/polymer that can be sintered after fabrication. The first connector 3 may additionally undergo surface treatments to provide appropriate surface roughness and/or wear resistance in particular for polymer components an O₂ plasma treatment but it can also consist of a thin film coating like Molecular Vapor Deposition (MVD) or Atomic Layer Deposition (ALD).

In the example of Figures 1A and 1B it shows a symmetrical shape of a dual-pin connector 3, having a first pin 31 and a second pin 32 extending along a common axis Y-Y' with a collar 33 extending perpendicularly to said longitudinal axis Y-Y' along an axis of symmetry X-X' of the connector 3. The collar 33 advantageously helps the handling of the first connector 3 by a robot or an operator to allow proper orientation and positioning of the connector 3 and its pins 31, 32 in alignment with the connecting holes 4 in each of the elements 1, 2 to assemble. It may also serve as a spacer between the elements 1,2 as shown in Figure 1B, to leave a gap easing the further separation and disassembly of the elements 1, 2 if needed.

The dimensions of the connector 3 in all directions of space X,Y,Z are preferably comprised between at least 1 micron and at most 5 mm, still preferably between 100 micron and 1 mm at most.

In addition, the shape of a cross-section of the pins 31, 32 of the connector 3 in a plan parallel to a plan X,Z perpendicular to the longitudinal axis Y-Y' of the pins may preferably be a regular shape, such as circular, square, rectangular or triangular.

To ensure a proper tight fit of the pins 31, 32 in the connecting holes 4, the holes preferably have substantially identical dimensions as the pins and identical shapes in a plan parallel to the plan X,Z so as to ensure that insertion of the pins in the holes 4 results from a force exerted along the longitudinal axis Y-Y' of the pins so as to push them in the holes 4 in such a way that an elastic or plastic deformation of the pins 31, 32 and/or the holes 4 occurs at the interfaces therebetween to ensure an airtight and leak-proof fit and adjustment between the connector's pins 31, 32 and the holes 4 of the elements 1,2 thereby assembled.

The assembly of the two elements 1,2 in that first embodiment of the method of the invention therefore comprises symmetrical pining of the elements 1,2 with on the pins 31, 32 of the first connector 3.

A second embodiment of the process of the invention is presented in figures 2A and 2B. In this second embodiment, a first connector 3 forming a single pin is formed by additive manufacturing according to any of the technique previously cited on the surface of one of the elements 1,2 to be assembled together, the remaining element comprising a connecting hole 4 as in the first embodiment of figures 1A and 1B.

In the represented embodiment the connector 3 is formed on a surface of element 2 while element 1 comprises the connecting hole 4 to fit in the connector 3 and realize the assembly of the elements 1, 2 by pining. The dimensions and shapes and the connector 3 and hole 4 must respect the principles previously defined in the first embodiment and will not be discussed in more detail here. However, in that second embodiment a closer and tighter assembly is provided as no spacing is arranged between the elements 1,2 through the connector 3, which does not comprise any collar. However, should such spacing be necessary provision of a spacer in the form of a collar at the base of connector 3 could easily be arranged in the course of 3D printing of the connector on element 2.

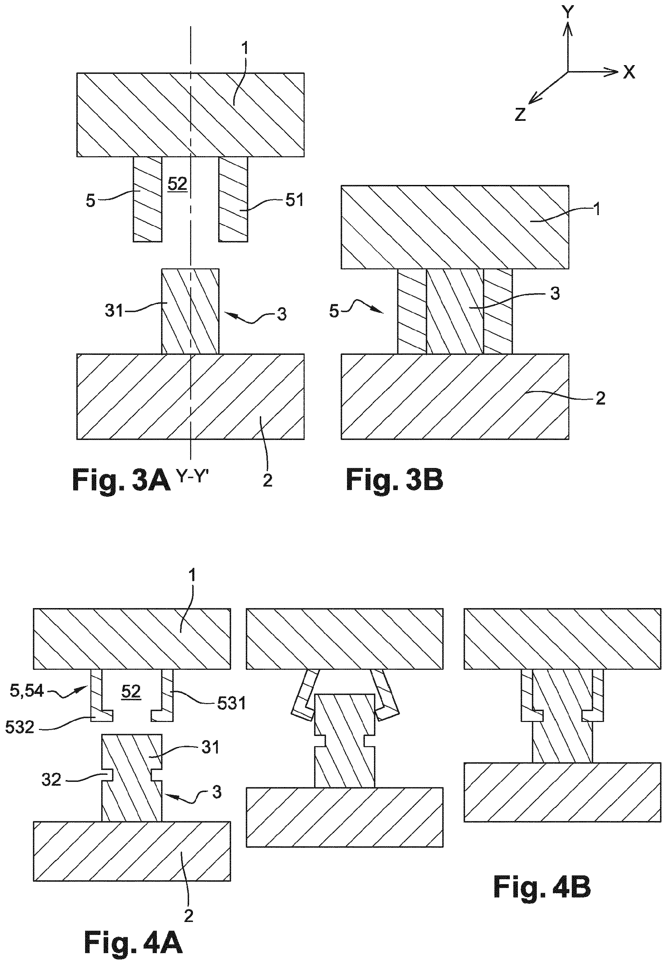

A third embodiment of the process of the invention is further represented in figures 3A and 3B. This third embodiment is similar to the second except for the replacement of the connecting hole 4 in the body of one of the elements 1, 2 to be assembled by a second connector 5 being, as for the first connector 3, formed by additive manufacturing technique on a surface of the remaining element 1.

The said second connector 5 is conformed as a female connector forming a socket having a tubular wall 51 extending from a surface of the first element 1 and having an insertion opening 52 at its tip opposite said first element. The wall 51 has a tubular cross-section in a horizontal plane parallel to the plan X,Z and its inner dimensions and shapes, i.e. the dimensions and shape of the inner channel 52 delimited by the wall 51 are identical to those of the pin forming the first connector 3 on the second element 2. As a result, reversible assembly of the two elements 1, 2 is achieved upon insertion of the first connector 3 in force into the inner channel 52, which induces elastic or plastic deformation of the wall 51 and/or the pin 3 and friction forces between the surfaces thereof allowing holding in place of the assembly.

Advantageously, the thickness of the wall 51 of the second connector 5 may be adjusted to provide more or less flexibility to said walls in order to allow elastic or plastic deformation thereof upon insertion of the first connector 3 therein to realize the assembly, which may provide easier assembly with less force required depending on the materials of the first and second connectors 3, 5.

Moreover, in such embodiment the two elements 1,2 once assembled remain at a distance from each other, i.e. with a gap in between, said gap being substantially equal to the maximum height or length of the second connector 5 from its base to its tip. Such gap may by advantageous in microsystems requiring a distance between two parts for allowing movement of one of the parts compared to the second part and thus without contact of the two parts.

Again in that third embodiment the dimensions and shapes of the connectors 3, 5 in all directions of space X, Y, Z respect the principles defined in reference with the first embodiment of figures 1A and 1B above preferably.

A fourth embodiment of the invention is represented in figures 4A to 4C. Again, it provides a male first connector 3 in the form of a pin, for example of c and a female second connector 5 being formed respectively by additive manufacturing technique on opposing surfaces of a first element 1 and a second element 2 of to be assembled. The mechanical assembly of the two elements 1, 2 this time results not only from insertion of the first connector 3 in the second connector 5 inducing elastic or plastic deformation but also from a clamping effect of the second connector 5 onto the first connector 3 to prevent unintentional removal of the pin 31 from the channel 52 of the second connector 5.

To that aim, the pin 31 of the first connector comprises a peripheral groove 32 advantageously configured to accommodate insertion therein of flexible hooks 53 formed by 3D printing on the surface of the first element 1 and extending therefrom so as to form the second connector 5, which constitutes a clamp 54 as can be seen in figures 4A to 4C. The peripheral groove 32 may be formed during 3D printing of the first connector 3 or machined in said connector after 3D printing. Of course, the peripheral groove 32 may also be replaced by individual notches or recesses regularly arranged in the surface of the connector 3 and not forming a full annular groove 32 as previously described, which forms the simples configuration to achieve.

The hooks 53 may preferably be formed as studs 531 extending substantially perpendicularly from the surface of an element 1 to be assembled and having a length of about 0.5 mm to 5 mm with a bend 532 formed at the tip of the studs to create a hook shape. The process of the invention, which contemplates 3D printing of the connectors 3, 5, is particularly advantageous as realization of such small complex shapes is usually difficult to achieve at microscale level for very small connectors.

The studs 531 are further arranged to be flexible with respect to the element 1 from which they protrude thanks to a reduced thickness, measured in the X direction on the figures, of about 0.1 mm to 2 mm. Such thickness hence allows for easier deformation of the hooks 53 upon insertion of the pin 31 of the first connector in the clamp 54 as represented in figure 4B. The pin 31 may further be machined or formed at its free end (or tip) such to have smoother edges, in particular rounded edges, in order to further smoothen introduction of the pin 31 in the hooks of the clamp 54 forming the second connector 5 and help pushing the flexible hooks away from each other as shown in figure 4B until said hooks fall into the groove 52 to clamp the second connector 5 on the first connector 3 as shown in figure 4C.

Once clamping is achieved the assembly of the two elements 1, 2 is secured and may not be reversed until an external action is completed to unlock the hooks from the groove 32 or to simply break it to release connectors 3, 5 from each other.

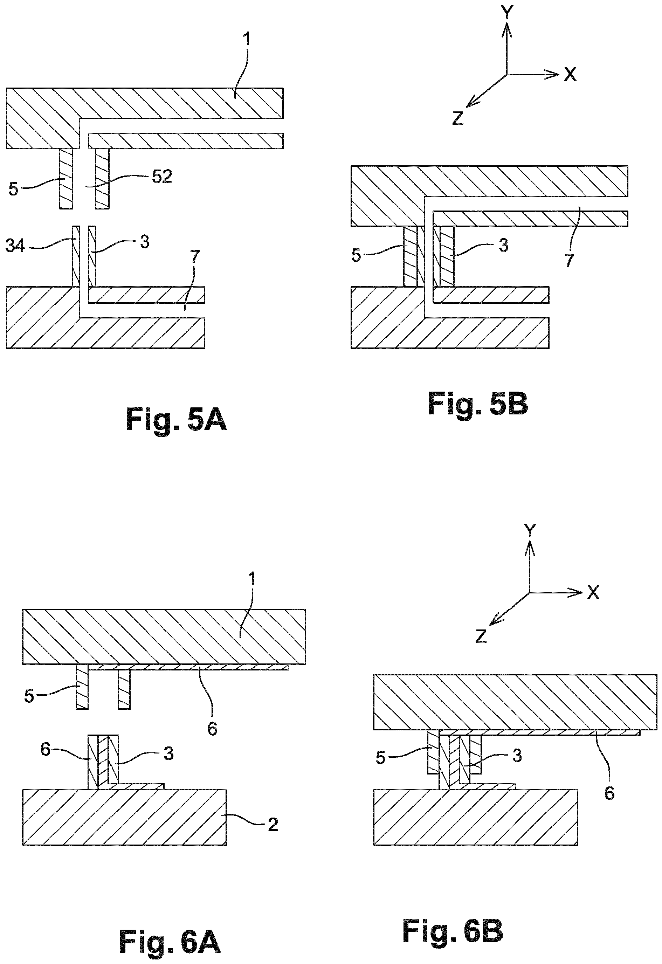

The process of the invention not only provides for an improved mechanical assembly between different elements of a microsystem but it may also help simplifying electrical, optical or even fluidic connections between such elements through the provision of 3D printed connectors as represented in figures 5 to 7 and described below in connection with those figures.

The embodiments represented in figures 5 to 7 rely on the provision of 3D printed first and second connectors 3, 5 on elements 1,2 of a microsystem to be assembled together as represented and described in Figure 3A and 3B above. However, in addition, both connectors 3, 5 also comprise an inner channel through their entire length along their longitudinal axis Y-Y'. Accordingly, both connectors 3, 5 are made to integrate other functions like electrical, fluidic or optical connections.

For example, Figure 5A and 5B show an embodiment where an empty hollow channel 34, 52 is provided in the 3D connectors 3, 5 for making a fluidic connecting arrangement between fluidic channels 7 in the elements 1, 2 to be connected. Such embodiment can be extremely advantageous for example to create MEMS manifolds and or lab-on-chip MEMS for chemical and biological analysis.

As further represented in figures 6A and 6B, the hollow channel 34 of the male connector 3 may further be filled with a conductive material 6 to form an electrical interconnections when the elements 1, 2, which individually comprise electrical circuitry deposited or printed therein by any known technique, are connected together through the connectors 3, 5. Typically, the electrical conductive material may be made of metal filled in the channel 35 of the first connector 3 or deposited in layers together with the material of the first connector 3 by additive manufacturing technique as contemplated in the invention and defined above, including not exclusively selective laser melting (SLM), selective laser sintering (SLS), aerosol jet printing (AJP),electron beam melting (EBM), Fused Filament Fabrication (FFF) or Stereolithography (SLA). The conductive material may for example be a metal selected among silver (Ag), aluminium (Al), gold (Au), titan (Ti), copper, (Cu), nickel (Ni), platinum (Pt), iron (Fe), or a conductive polymer composite charged with metal particles or carbon based particles (graphene, carbon nanotube).

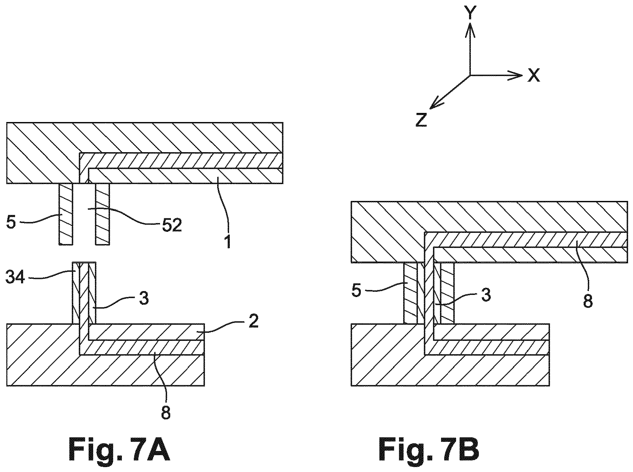

The channel 34 of the first connector 3 can also be filled with an optically conductive transparent material 8 that can connect optical waveguides or optical fibers embedded in the elements 1, 2 connected thanks to the 3D printed connectors 3, 5 according to the process of the invention to make an optical connection as represented in the embodiment of Figures 7A and 7B.

Of course in the embodiments of figures 6 and 7 one can also easily contemplate forming the connectors 3, 5 directly from the electrically or optically conductive material to avoid filing in a channel therein, in particular using aerosol jet printing or fused filament technique for example.

The process of the invention therefore provides for an easy to implement, easy to adapt, versatile solution for connecting elements of microsystems, eventually in a reversible way thanks to the provisions of connectors formed by additive manufacturing techniques on a surface of the elements to be connected, said connectors being easily functionalized to ensure not only mechanical connection but also fluidic, electrical or optical connection between the connected elements.

## Claims

1. A process for reversibly assembling at least two elements (1, 2) comprising the steps of
- providing at least a first connector (3), and
- connecting the at least two elements (1, 2) by means of the first connector (3),
wherein the at least first connector (3) is formed by additive manufacturing technique without molding or masking, and wherein the connector and/or the elements (1,2) are configured to undergo elastic or plastic deformation upon connection and/or disconnection of the two parts (1,2).

2. A process according to claim 1, wherein the additive manufacturing technique comprises, material jetting, nanoparticle jetting, drop on demand technique, binder jetting, multijet fusion selective laser sintering, direct metal laser sintering, selective laser melting, aerosol jet printing, stereolithography, digital light processing, continuous digital light processing, fused filament deposition modelling, or electron beam melting, electron beam additive manufacturing, laser engineering net shapeor any combination thereof.

3. A process according to any of claims 1 or 2, wherein the first connector (3) is made of a material comprising a polymer, a metal, a metallic alloy, a ceramic or a combination thereof.

4. A process according to any of the preceding claims, wherein any dimension of said at least first connector (3) in any dimension X,Y,Z of space is comprised between of at least 10 microns and at most 5 mm.

5. A process according to any of the preceding claims, wherein the first connector (3) is a pin and connecting the at least two elements (1, 2) comprises pining the two elements together by means of the at least first connector (3).

6. A process according to claim 5, wherein said two elements (1, 2) comprise each at least one hole (4) having complementary shape and dimensions with the at least one connector (3) so that it can be inserted in and removed from said hole (4) by elastic or plastic deformation of the connector and/or hole walls.

7. A process according to claim 5, wherein said at least first connector (3) is formed onto one of the two elements (1, 2) and the other one of the two elements comprises at least one hole (4) having complementary shape and dimensions with the at least one connector (3) so that it can be inserted in and removed from said hole by elastic or plastic deformation of the connector and/or hole walls.

8. A process according to any of claims 1 to 4, wherein the first connector (3) is formed on a first one (1) of the two elements and wherein at least a second connector (5) is provided on the second one (2) of the two elements, said first and second connectors (3, 5) having complementary male and female shapes such that one connector can be inserted into the other connector by elastic deformation of one or both connectors to connect said two elements (1,2).

9. A process according to claim 8, wherein a first connector is a pin extending perpendicularly from a surface of one elements (1) comprising a peripheral groove (32) and the second connector comprises flexibles hooks (53) extending perpendicularly from a surface of the second element (2) and being flexible and arranged with respect to each other such that connection of the two elements (1, 2) results from insertion of the first connector (3) between of the hooks (53) of the second connector (5) and clamping of the hooks in the groove of the first connector.

10. A process according to any of claims 8 or 9, wherein the first and second connectors (3, 5) are tubular and comprise at least a central channel (35, 53) extending along a length of said connectors, said channels communicating with each other upon insertion of the connectors into each other to connect the two elements.

11. A process according to claim 8 and 10, wherein the first and second connectors (3, 5) are arranged such that connection between the two elements is air and fluid tight at the connectors.

12. A process according to claim 10 or 11, wherein the channel in the first and second connectors (3, 5) is filled with electrically conductive material or optically conductive material.

13. A process according to claim 12, wherein the electrically conductive material or optically conductive material is deposited in the channel by additive manufacturing technique, in particular any technique referred in claim 2.

14. A process according to any preceding claims, wherein the first and/or a second connector are made of electrically conductive material or optically conductive material by additive manufacturing technique, in particular any technique referred in claim 2.

15. A process according to any of claims 7 to 14, wherein said at least second connector has a longest dimension in any dimension X,Y,Z of space of at least 10 micron and of at most 5 mm.

16. A process according to any of claims 1 to 14, wherein the two elements (1,2) belong to any of the following component families: MEMS, MacroMEMS, BioMEMS, MOEMS, NEMS, microfluidic components or mechanical components.
